# EUROPÄISCHE PATENTSCHRIFT

(11) **EP 2 529 483 B1**
(45) Veröffentlichungstag und Bekanntmachung des Hinweises auf die Patenterteilung: **07.08.2019**
(21) Anmeldenummer: 11700683.3
(22) Anmeldetag: 24.01.2011
(51) Int. Cl.: H03K 17/96, H03K 17/00

(54) **SCHALTUNGSANORDNUNG ZUM BESTIMMEN EINER KAPAZITÄT EINER ANZAHL VON KAPAZITIVEN SENSORELEMENTEN**
CIRCUIT ASSEMBLY FOR DETERMINING A CAPACITY OF A NUMBER OF CAPACITIVE SENSOR ELEMENTS
CIRCUITERIE POUR DÉTERMINER UNE CAPACITÉ D'UN CERTAIN NOMBRE D'ÉLÉMENTS DE DÉTECTION CAPACITIFS

(30) Priorität: 29.01.2010 DE 102010001377
(43) Veröffentlichungstag der Anmeldung: 05.12.2012
(73) Patentinhaber: E.G.O. Elektro-Gerätebau GmbH, 75038 Oberderdingen (DE)
(72) Erfinder: KRAUS, Randolf, 75015 Bretten (DE)
(74) Vertreter: Patentanwälte Ruff, Wilhelm, Beier, Dauster & Partner mbB
(86) Internationale Anmeldenummer: PCT/EP2011/050889
(87) Internationale Veröffentlichungsnummer: WO 2011/092134

(56) Entgegenhaltungen:
- EP-A2- 0 093 565
- WO-A1-99/38149
- US-A1- 2009 224 776
- US-B1- 6 452 514
- Na: "CapSense System in Cypress Semiconductor: PSoC Technical Reference Manual (TRM)", , 9 July 2009 (2009-07-09), page div, XP055327243, INTERNET Retrieved from the Internet: URL:https://engineering.purdue.edu/ece477/ Archive/2009/Fall/F09-Grp05/datasheets/Cap Sense/cy8c20x66.pdf [retrieved on 2016-12-08]
- KAZUYUKI KONDO ET AL: "A Switched-Capacitor Digital Capacitance Meter", ELECTRONICS & COMMUNICATIONS IN JAPAN, PART II - ELECTRONICS, WILEY, HOBOKEN, NJ, US, vol. 70, no. 2, 1 February 1987 (1987-02-01), pages 101-111, XP002131804, ISSN: 8756-663X

## Beschreibung

### Anwendungsgebiet und Stand der Technik

Die Erfindung betrifft eine Schaltungsanordnung zum Bestimmen einer Kapazität einer Anzahl von kapazitiven Sensorelementen.

Schaltungsanordnungen zur Auswertung kapazitiver Näherungsschalter verwenden üblicherweise kapazitive Sensorelemente, deren Kapazität sich betätigungsabhängig ändert. Diese Kapazitätsänderung wird ausgewertet, um den Betätigungszustand zu ermitteln.

Bei Schaltungsanordnungen, die nach dem so genannten Switched-Capacitor-Prinzip arbeiten, wird das kapazitive Sensorelement üblicherweise über ein Schaltmittel mit einer Ladespannung beaufschlagt, wodurch in Abhängigkeit von dessen Kapazität und der Ladespannung eine bestimmte elektrische Ladung auf das kapazitive Sensorelement transferiert wird. Nach einer Ladezeit wird das Sensorelement mittels des Schaltmittels von der Ladespannung getrennt und über ein weiteres Schaltmittel mit einem Sammelkondensator bzw. einem Referenzkondensator bekannter Kapazität verbunden, wodurch ein Ladungstransfer vom Sensorelement auf den Sammelkondensator erfolgt. Der Vorgang des Ladens und anschließenden Umladens wird für eine vorbestimmte Anzahl von Zyklen wiederholt, wodurch die Ladung des Sammelkondensators einen bestimmten Wert erreicht, der unter anderem durch den Wert der Kapazität des Sensorelements bestimmt wird. Die Ladung bzw. die daraus resultierende Spannung des Sammelkondensators ist folglich ein Maß für die zu messende Kapazität des Sensorelements. Durch Auswerten der Spannung des Sammelkondensators kann auf den Betätigungszustand des Näherungsschalters geschlossen werden. Nach der Spannungsauswertung wird der Sammelkondensator üblicherweise definiert entladen und es kann sich ein neuer Messzyklus anschließen.

Die US 6,452,514 B1 zeigt eine Schaltungsanordnung, bei der ein kapazitives Sensorelement und ein Kondensator mit bekannter Kapazität mit einem Spannungspuls beaufschlagt werden, während die Kondensatoren in Serie geschaltet sind. Die sich dann einstellende Spannung ist ein Maß für die Kapazität des kapazitiven Sensorelements.

Die WO 99/38149 A1 zeigt eine Schaltungsanordnung, die nach dem Switched-Capacitor-Prinzip arbeitet, wobei ein erster Schalter für einen Ladezyklus vorgesehen ist und ein zweiter, vom ersten Schalter getrennter Schalter für den Ladungstransferzyklus vorgesehen ist.

Aus der US 2009/0224776 A1 ist eine weitere Schaltungsanordnung bekannt für einen Berührschalter, bei der ein Ladungstransfer genutzt wird. Dort ist jeweils einem einzigen Sensorelement eine Mehrzahl von Wechselschaltern zugeordnet.

Das Dokument "CapSense System in Cypress Semiconductor: PSoC Technical Reference Manual (TRM)", 9. Juli 2009, XP055327243, URL:https://engineering.purdue.edu/ece4 77 I Archive/2009/Faii/F09-G rp05/datasheets/CapSense/cy8c20x66.pdf" ist eine technische Beschreibung für Halbleiterbauelemente. Damit können Wechselschalter auf bestimmte Art und Weise angesteuert werden. Ein Wechselschalter verbindet einen Anschlusspin aber in Abhängigkeit von einem Switch-Enable-Signal mit einem analogen globalen Bus. Mittels eines Discharge-Clock-Signals kann ein Schalter gegen Masse geschlossen werden für ein definiertes Entladen eines Kondensators gegen Masse.

Aus der EP 93565 A2 ist eine weitere Berührungsschalteranordnung bekannt. Dort werden Multiplexer verwendet, um mehrere Berührungs-Elektroden auszuwerten.

Aus dem Dokument "KAZUYUKI KONDO ET AL: "A Switched-Capacitor Digital Capacitance Meter", ELECTRONICS & COMMUNICATIONS IN JAPAN, PART IIELECTRONICS, WILEY, HOBOKEN, NJ, US, Bd. 70, Nr. 2, 1. Februar 1987 (1987-02-01), Seiten 101-111, XP002131804, ISSN: 8756-663X" geht hervor, was ein Fachmann unter dem Messprinzip des Switched-Capacitor-Prinzips versteht. Eine konkrete Beschaltungsmöglichkeit ist darin nicht beschrieben.

### Aufgabe und Lösung

Der Erfindung liegt als Aufgabe die Bereitstellung einer Schaltungsanordnung zum Bestimmen einer Kapazität einer Anzahl von kapazitiven Sensorelementen nach dem Switched-Capacitor-Prinzip zugrunde, die durch Auswertung der Kapazität bzw. der Kapazitätsänderung eine sichere Ermittlung des Betätigungszustands unter allen Betriebsbedingungen gewährleistet, kostengünstig herstellbar und unempfindlich gegenüber EMV- und HF-Störungen ist.

Die Erfindung löst diese Aufgabe durch eine Schaltungsanordnung mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Die Schaltungsanordnung zum Bestimmen einer Kapazität einer Anzahl n von kapazitiven Sensorelementen, deren jeweilige Kapazität sich betätigungsabhängig ändert, umfasst mindestens einen Sammelkondensator, bevorzugt mit bekannter Kapazität, eine Referenzspannungsquelle, insbesondere zum Erzeugen einer zeitlich konstanten Referenzspannung bzw. Referenzpotentials, die mit einer Versorgungsspannung bzw. einem Massepotential übereinstimmen kann, eine mit dem mindestens einen Sammelkondensator elektrisch verbundene Auswerteeinrichtung, beispielsweise einen Mikroprozessor mit integriertem A/D-Wandler, welche bzw. welcher eine an dem mindestens einen Sammelkondensator anstehende Spannung zum Bestimmen der Kapazität eines jeweiligen Sensorelements auswertet, und eine Steuereinheit, beispielsweise ebenfalls ein Mikroprozessor, der ebenfalls die Auswerteeinrichtung bilden kann, zur Erzeugung mindestens eines Steuersignals und mindestens einen integrierten Schaltkreis, der mit der Referenzspannungsquelle und dem mindestens einen Sammelkondensator elektrisch verbunden und mit dem mindestens einen Steuersignal beaufschlagt ist. Der mindestens eine integrierte Schaltkreis umfasst eine Anzahl k von Wechselschaltern, auch als Umschalter, Wechsler oder analoger 2-Kanal Multiplexer/Demultiplexer bezeichnet, wobei k bevorzugt größer als 1 ist, wobei ein jeweiliger Wechselschalter jeweils einem der Anzahl n von Sensorelementen zugeordnet ist, eine Schaltstellung eines jeweiligen Wechselschalters von dem mindestens einen Steuersignal abhängt und ein jeweiliger Wechselschalter in einer ersten Schaltstellung das jeweils zugeordnete Sensorelement mit der Referenzspannungsquelle verbindet, was einem Ladezyklus des Switched-Capacitor-Prinzips entspricht, und der jeweilige Wechselschalter in einer zweiten Schaltstellung das jeweils zugeordnete Sensorelement mit dem mindestens einen Sammelkondensator zum Ladungstransfer verbindet, was einem Ladungstransferzyklus des Switched-Capacitor-Prinzips entspricht. Aufgrund der Bündelung der Wechselschalter in den oder die integrierten Schaltkreise und der Tatsache, dass Leitungen zur Referenzspannungsquelle und zu dem oder den Sammelkondensatoren überwiegend innerhalb der integrierten Schaltkreise geführt sind, kann die Anzahl der benötigten Bauelemente und der Layout-Aufwand reduziert werden, wodurch die Schaltungsanordnung im Vergleich zu Lösungen mit diskreten Schaltmitteln bzw. Umschaltern kostengünstiger herstellbar und unempfindlicher gegenüber EMV- und HF-Störungen ist.

In einer Weiterbildung ist die Anzahl n von kapazitiven Sensorelementen eine ganzzahlige Vielfache der Anzahl k von ansteuerbaren Wechselschaltern des integrierten Schaltkreises. Beispielsweise kann die Anzahl k von ansteuerbaren Wechselschaltern eines einzelnen integrierten Schaltkreises 3 betragen und es können insgesamt vier integrierte Schaltkreise verwendet werden, so dass insgesamt n=12=3*4 kapazitive Sensorelemente auswertbar sind.

In einer Weiterbildung ist jedem integrierten Schaltkreis jeweils genau ein Sammelkondensator zugeordnet, wobei eine Anzahl von unterschiedlichen Steuersignalen erzeugt wird, die gleich der Anzahl k von Wechselschaltern in einem jeweiligen integrierten Schaltkreis ist. Alternativ ist allen integrierten Schaltkreisen gemeinsam eine Anzahl von Sammelkondensatoren zugeordnet, die gleich der Anzahl von Wechselschaltern in einem jeweiligen integrierten Schaltkreis ist, wobei eine Anzahl von unterschiedlichen Steuersignalen erzeugt wird, die gleich der Anzahl von integrierten Schaltkreisen ist.

In einer Weiterbildung ist mindestens eine Ladeschaltung vorgesehen, die dazu ausgebildet ist, den mindestens einen Sammelkondensator vor dem Beginn einer Messung aufzuladen, wobei die Referenzspannungsquelle dazu ausgebildet ist, die Massespannung auszugeben bzw. den mindestens einen Sammelkondensator mit dem Massepotential zu verbinden. Die Ladeschaltung kann beispielsweise als Schaltmittel ausgebildet sein, welches den Sammelkondensator zum Aufladen mit einer Spannungsquelle verbindet.

Vorteilhafte Ausführungsformen der Erfindung sind in den Zeichnungen schematisch dargestellt und werden nachfolgend beschrieben. Hierbei zeigt:

### Kurzbeschreibung der Zeichnungen

- Fig. 1: ein Prinzip-Schaltbild einer ersten Ausführungsform einer Schaltungsanordnung zum Bestimmen einer Kapazität einer Anzahl n von kapazitiven Sensorelementen,
- Fig. 2: ein Prinzip-Schaltbild einer weiteren Ausführungsform einer Schaltungsanordnung zum Bestimmen einer Kapazität einer Anzahl n von kapazitiven Sensorelementen,
- Fig. 3: ein Prinzip-Schaltbild einer weiteren Ausführungsform einer Schaltungsanordnung zum Bestimmen einer Kapazität einer Anzahl n von kapazitiven Sensorelementen und
- Fig. 4: ein Prinzip-Schaltbild einer weiteren Ausführungsform einer Schaltungsanordnung zum Bestimmen einer Kapazität einer Anzahl n von kapazitiven Sensorelementen.

### Detaillierte Beschreibung der Zeichnungen

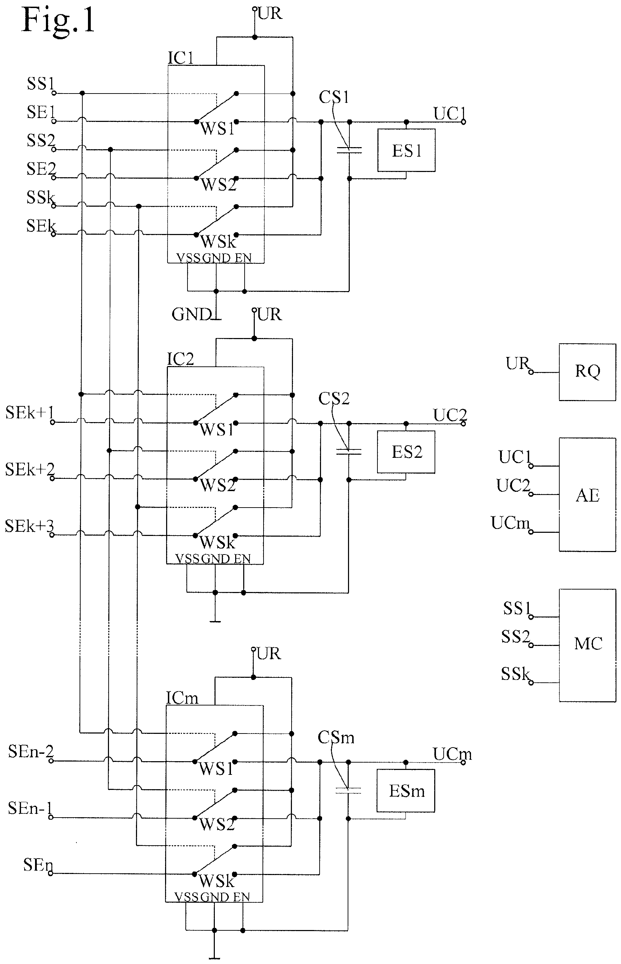

Fig. 1 zeigt ein Prinzip-Schaltbild einer ersten Ausführungsform einer Schaltungsanordnung zum Bestimmen einer Kapazität einer Anzahl n von kapazitiven Sensorelementen SE1 bis SEn. Die Anzahl n kann beispielsweise 12 betragen.

Die kapazitiven Sensorelemente SE1 bis SEn bilden jeweils einen Kondensator, wobei eine erste Kondensatorplatte in herkömmlicher Weise durch eine nicht gezeigte, leitfähige, insbesondere ebene und flächige Schicht gebildet sein kann, die beispielsweise unter einer Glaskeramikplatte eines nicht gezeigten Kochfeldes angeordnet sein kann. Eine zweite Kondensatorplatte wird beispielsweise durch einen nicht gezeigten Finger eines Bedieners bzw. durch den Bediener selbst gebildet. Die Glaskeramikplatte bildet ein Dielektrikum zwischen den beiden Kondensatorplatten.

Die Schaltungsanordnung umfasst eine Anzahl m von integrierten Schaltkreisen IC1 bis ICm, wobei m beispielsweise vier ist. Die integrierten Schaltkreise können beispielsweise vom Typ HCT 4053 sein.

Weiter ist eine Referenzspannungsquelle RQ vorgesehen, die beispielsweise eine Referenzspannung UR mit +5V DC liefert.

Eine Steuereinheit MC erzeugte eine Anzahl k von Steuersignalen SS1 bis SSk, wobei k beispielsweise drei ist.

Die integrierten Schaltkreise IC1 bis ICm sind jeweils mit der Referenzspannungsquelle UR und mit zugehörigen Sammelkondensatoren CS1 bis CSm bekannter Kapazität wie dargestellt elektrisch verbunden. Die Steuersignale SS1 bis SSk sind an entsprechende Eingänge der integrierten Schaltkreise IC1 bis ICm angelegt. Weiter sind Eingänge Vss, GND und EN der integrierten Schaltkreise IC1 bis ICm mit Masse GND verbunden. Des Weiteren sei auch auf Datenbücher zum Typ HCT 4053 verwiesen.

Die integrierten Schaltkreise IC1 bis ICm umfassen jeweils eine Anzahl k von Wechselschaltern WS1 bis WSk, wobei ein jeweiliger Wechselschalter WS1 bis WSk der integrierten Schaltkreise IC1 bis ICm jeweils einem der Anzahl n von Sensorelementen SE1 bis SEn zugeordnet ist. Eine Schaltstellung eines jeweiligen Wechselschalters WS1 bis WSk hängt von den Steuersignalen SS1 bis SSk ab. Ein jeweiliger Wechselschalter WS1 bis WSk verbindet in einer ersten Schaltstellung das jeweils zugeordnete Sensorelement SE1 bis SEn mit der Referenzspannungsquelle UR und verbindet in einer zweiten Schaltstellung das jeweils zugeordnete Sensorelement SE1 bis SEn mit dem zugehörigen Sammelkondensator CS1 bis CSm des integrierten Schaltkreises IC1 bis ICm zum Ladungstransfer.

Eine mit den Sammelkondensatoren CS1 bis CSm elektrisch verbundene Auswerteeinrichtung AE wertet an den Sammelkondensatoren CS1 bis CSm anstehende Spannungen zum Bestimmen der Kapazität des jeweiligen Sensorelements SE1 bis SEn aus.

Entladeschaltungen ES1 bis ESn dienen zum definierten Entladen der Sammelkondensatoren CS1 bis CSm vor dem Beginn einer Messung. Die Entladeschaltungen ES1 bis ESn können beispielsweise jeweils als Schaltmittel ausgebildet sein, welche die Sammelkondensatoren CS1 bis CSm zum Entladen mit Masse GND verbinden.

Nachfolgend wird ein Messzyklus exemplarisch beschrieben. Am Beginn eines Bestimmungs- bzw. Messzyklus werden die Steuersignale SS1 bis SSk derart erzeugt, dass sämtliche Sensorelemente SE1 bis SEn mit der Referenzspannungsquelle UR verbunden sind. Die Entladeschaltungen ES1 bis ESn entladen die Sammelkondensatoren CS1 bis CSm.

Nun erfolgt zunächst eine Kapazitätsbestimmung derjenigen kapazitiven Sensorelemente, deren zugehöriger Wechselschalter, hier jeweils WS1, mit dem Steuersignal SS1 angesteuert ist. Hierzu wird das Steuersignal SS1 als Rechtecksignal erzeugt und die Steuersignale SS2 bis bzw. und SSk verbleiben konstant auf einem solchen Pegel, der bewirkt, dass die zugehörigen Sensorelemente mit der Referenzspannungsquelle UR verbunden bleiben.

Das Steuersignal SS1 als Rechtecksignal bewirkt, dass wiederholt Lade- und anschließend Umladezyklen erfolgen, wodurch die Sammelkondensatoren CS1 bis CSm schrittweise aufgeladen werden, wobei eine Spannungsänderung pro Zyklus von der zu messenden Kapazität des jeweiligen Sensorelements abhängt. Nach einer vorgegebenen Anzahl von Zyklen wertet die Auswerteeinrichtung AE eine an den Sammelkondensatoren CS1 bis CSm anstehende Spannung zur Kapazitätsbestimmung aus. Alternativ kann eine Anzahl von Lade- und Umladezyklen gezählt werden, die notwendig ist, dass ein vorgegebener Spannungswert an einem Sammelkondensator erreicht bzw. überschritten wird. Die Kapazitäten der Sammelkondensatoren CS1 bis CSm können bekannt sein, beispielsweise durch geeignete Bauelementauswahl mit vorgegebenen Kapazitätswerten. Die Kapazitäten der Sammelkondensatoren CS1 bis CSm müssen jedoch nicht zwingend innerhalb enger Toleranzen liegen, da auch eine Kalibrierung während des Betriebs möglich ist, wobei hier während des Betriebs geeignete Schwellenwerte bestimmt werden können, die eine Unterscheidung zwischen unterschiedlichen Kapazitätsstufen ermöglichen. Im einfachsten Fall ist lediglich ein einzelner Schwellenwert zur Unterscheidung von zwei unterschiedlichen Kapazitätswerten zu ermitteln, wobei ein erster Kapazitätswert einem nicht betätigten Sensorelement entspricht und ein zweiter Kapazitätswert einem betätigten Sensorelement entspricht.

Im Anschluss wird das Steuersignal SS1 wieder derart statisch erzeugt, dass die zugehörigen Sensorelemente mit der Referenzspannungsquelle UR verbunden sind. Die Entladeschaltungen ES1 bis ESn entladen die Sammelkondensatoren CS1 bis CSm.

Dann erfolgt eine Kapazitätsbestimmung derjenigen kapazitiven Sensorelemente, deren zugehöriger Wechselschalter, hier jeweils WS2, mit dem Steuersignal SS2 angesteuert ist. Hierzu wird das Steuersignal SS2 als Rechtecksignal erzeugt und die Steuersignale SS1 und SSk verbleiben konstant auf einem solchen Pegel, der bewirkt, dass die zugehörigen Sensorelemente mit der Referenzspannungsquelle UR verbunden bleiben. Die Kapazitätsbestimmung erfolgt wie oben beschrieben.

Die genannten Schritte wiederholen sich k mal, bis die Kapazität aller Sensorelemente SE1 bis SEn bestimmt worden ist. Dann beginnt das beschriebene Verfahren von neuem.

Bei der in Fig. 1 gezeigten Ausführungsform ist pro integriertem Schaltkreis IC1 bis ICm genau ein Sammelkondensator vorgesehen, der im Zeitmultiplex zwischen den k Eingängen des jeweiligen integrierten Schaltkreises IC1 bis ICm geteilt wird. Hierzu sind insgesamt k unterschiedliche Steuersignale SS1 bis SSk notwendig.

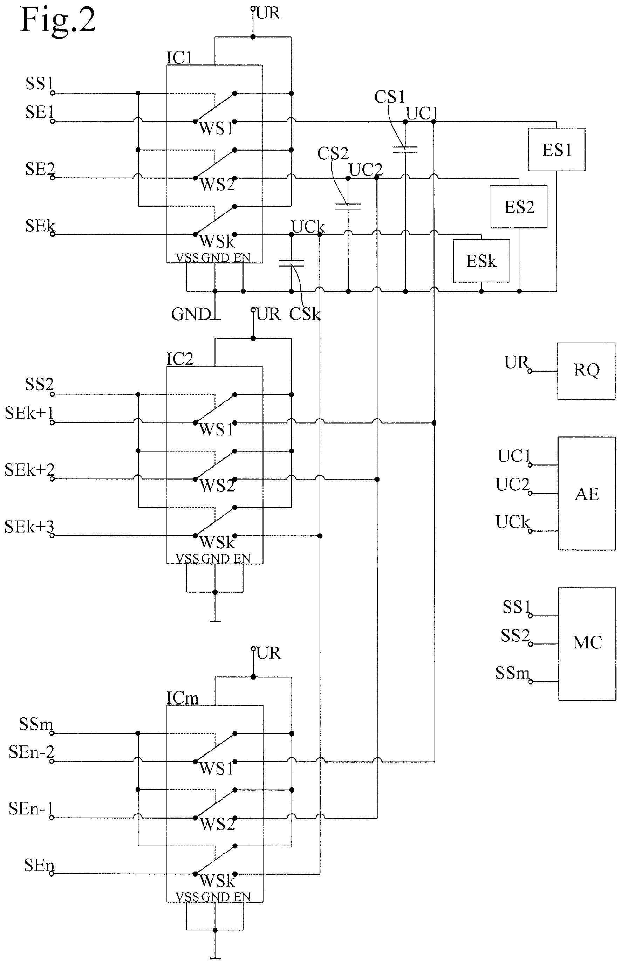

Fig. 2 zeigt ein Prinzip-Schaltbild einer weiteren Ausführungsform einer Schaltungsanordnung zum Bestimmen der Kapazität der Sensorelemente SE1 bis SEn, bei der sich alle integrierten Schaltkreise IC1 bis ICm Sammelkondensatoren CS1 bis CSk teilen.

Hierzu wird pro integriertem Schaltkreis IC1 bis ICm ein spezifisches Steuersignal SS1 bzw. SSm erzeugt, sodass sich die integrierten Schaltkreise IC1 bis ICm im Zeitmultiplex die Sammelkondensatoren CS1 bis CSk teilen. Mit anderen Worten wird zunächst die Kapazität der mit dem ersten integrierten Schaltkreis IC1 verbundenen Sensorelemente SE1 bis SEk bestimmt, indem das Sensorsignal SS1 als Rechtecksignal erzeugt wird und die verbleibenden Sensorsignale mit einem solchen Pegel erzeugt werden, der bewirkt, dass die zugehörigen Sensorelemente mit der Referenzspannungsquelle UR verbunden bleiben. Anschließend wird entsprechend die Kapazität der mit dem zweiten integrierten Schaltkreis IC2 verbundenen Sensorelemente bestimmt usw. Nachdem die die Kapazität aller Sensorelemente bestimmt worden ist, beginnt der Vorgang von vorne.

Bei den in Fig. 1 und 2 gezeigten Ausführungsformen erzeugt die Referenzspannungsquelle eine positive Referenzspannung, beispielsweise +5V, und die Sammelkondensatoren werden vor dem Beginn einer Messung entladen.

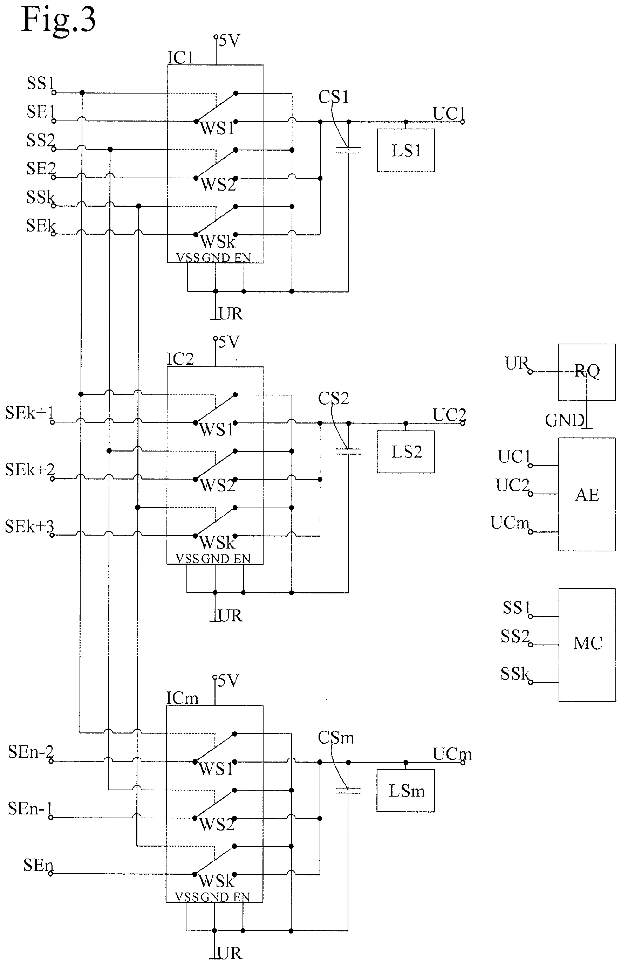

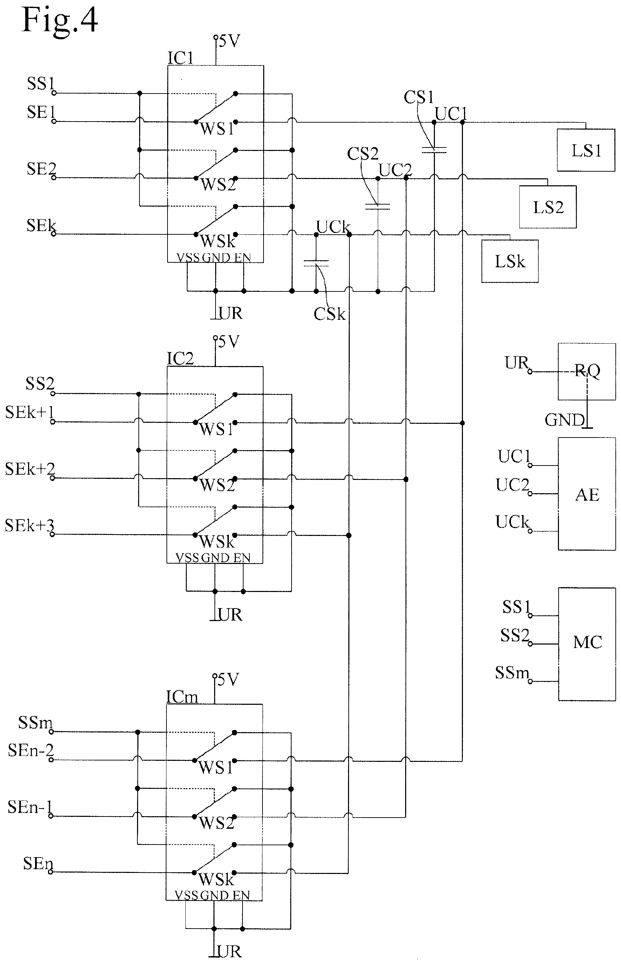

Bei den in den Figuren 3 und 4 gezeigten Ausführungsformen liefert die Referenzspannungsquelle RQ die Massespannung bzw. das Massepotential GND, d.h. UR=GND, und die Sammelkondensatoren werden vor dem Beginn einer Messung mittels der Ladeschaltungen LS1 bis LSm bzw. LS1 bis LSk auf eine Spannung, beispielsweise +5V, geladen. Wenn die Steuersignale als rechteckförmige Signale erzeugt werden, erfolgt daher mittels der Wechselschalter ein schrittweises Entladen der Sammelkondensatoren. Eine Spannungsänderung oder Spannungsreduktion pro Zyklus hängt von der zu messenden Kapazität des jeweiligen Sensorelements ab. Nach einer vorgegebenen Anzahl von Zyklen wertet die Auswerteeinrichtung AE eine an den Sammelkondensatoren CS1 bis CSm bzw. CS1 bis CSk anstehende Spannung zur Kapazitätsbestimmung aus. Alternativ kann eine Anzahl von Lade- und Umladezyklen gezählt werden, die notwendig ist, dass ein vorgegebener Spannungswert an einem Sammelkondensator erreicht bzw. unterschritten wird. Im Übrigen sei auf die Figuren 1 und 2 verwiesen.

Die Auswerteeinrichtung AE und die Steuereinheit MC können durch einen einzelnen Mikroprozessor realisiert sein.

Die gezeigten Ausführungsformen gewährleisten eine sichere Ermittlung des Betätigungszustands unter allen Betriebsbedingungen, sind kostengünstig herstellbar und unempfindlich gegenüber EMV- und HF-Störungen.

## Patentansprüche

1. Schaltungsanordnung zum Bestimmen einer Kapazität einer Anzahl n von kapazitiven Sensorelementen (SE1∼SEn), deren jeweilige Kapazität sich betätigungsabhängig ändert, nach dem Switched-Capacitor-Prinzip, das einen Ladezyklus und einen Ladungstransferzyklus umfasst, mit
- mindestens einem Sammelkondensator (CS1∼CSm; CS1∼CSk),
- einer Referenzspannungsquelle (RQ),
- einer mit dem mindestens einen Sammelkondensator elektrisch verbundenen Auswerteeinrichtung (AE), welche eine an dem mindestens einen Sammelkondensator anstehende Spannung zum Bestimmen der Kapazität eines jeweiligen Sensorelements auswertet,
- einer Steuereinheit (MC) zur Erzeugung mindestens eines Steuersignals (SS1∼SSk; SS1∼SSm) und
- mindestens einem integrierten Schaltkreis (IC1∼ICm), der mit der Referenzspannungsquelle und dem mindestens einen Sammelkondensator elektrisch verbunden und mit dem mindestens einen Steuersignal beaufschlagt ist, wobei der mindestens eine integrierte Schaltkreis umfasst:
- eine Anzahl k von Wechselschaltern (WS1∼WSk), wobei
- ein jeweiliger Wechselschalter jeweils einem der Anzahl n von Sensorelementen zugeordnet ist,
- eine Schaltstellung eines jeweiligen Wechselschalters von dem mindestens einen Steuersignal abhängt und
- ein jeweiliger Wechselschalter in einer ersten Schaltstellung das jeweils zugeordnete Sensorelement mit der Referenzspannungsquelle verbindet, was dem Ladezyklus des Switched-Capacitor-Prinzips entspricht, und der jeweilige Wechselschalter in einer zweiten Schaltstellung das jeweils zugeordnete Sensorelement mit dem mindestens einen Sammelkondensator zum Ladungstransfer verbindet, was dem Ladungstransferzyklus des Switched-Capacitor-Prinzips entspricht,
wobei der mindestens eine Sammelkondensator (CS1∼CSm; CS1∼CSk) mit einem Ende mit dem jeweiligen Wechselschalter (WS1∼WSk) verbunden ist und mit dem anderen Ende mit Masse (GND) verbunden ist,
und wobei Mittel (ES1∼ESm) vorhanden sind um den Sammelkondensator (CS1∼CSm; CS1∼CSk) zu entladen und die Verbindung des jeweiligen Sensorelementes mit der Referenzspannungsquelle (RQ) über den jeweiligen Wechselschalter (WS1∼WSk) zu einem von Masse verschiedenen Potential (UR) erfolgt,
oder wobei Mittel (LS1∼LSm) vorhanden sind um den Sammelkondensator (CS1∼CSm; CS1∼CSk) an dem nicht mit Masse verbundenen Ende mit einem von Masse verschiedenen Potential aufzuladen und die Verbindung des jeweiligen Sensorelementes mit der Referenzspannungsquelle (RQ) über den jeweiligen Wechselschalter (WS1∼WSk) zu einem Massepotential (GND) erfolgt.

2. Schaltungsanordnung nach Anspruch 1, **dadurch gekennzeichnet, dass** die Anzahl n von kapazitiven Sensorelementen eine ganzzahlige Vielfache der Anzahl k von ansteuerbaren Wechselschaltern des mindestens einen integrierten Schaltkreises ist.

3. Schaltungsanordnung nach Anspruch 1 oder 2, **dadurch gekennzeichnet, dass** jedem integrierten Schaltkreis jeweils genau ein Sammelkondensator zugeordnet ist, wobei die Steuereinheit eine Anzahl von unterschiedlichen Steuersignalen erzeugt, die gleich der Anzahl k von Wechselschaltern in einem jeweiligen integrierten Schaltkreis ist.

4. Schaltungsanordnung nach Anspruch 1 oder 2, **dadurch gekennzeichnet, dass** allen integrierten Schaltkreisen gemeinsam eine Anzahl von Sammelkondensatoren zugeordnet ist, die gleich der Anzahl von Wechselschaltern in einem jeweiligen integrierten Schaltkreis ist, wobei die Steuereinheit eine Anzahl von unterschiedlichen Steuersignalen erzeugt, die gleich der Anzahl von integrierten Schaltkreisen ist.

5. Schaltungsanordnung nach einem der vorhergehenden Ansprüche, **gekennzeichnet durch** mindestens eine Ladeschaltung (LS1∼LSm, LS1∼LSk) als Mittel zum Aufladen des Sammelkondensators (CS1∼CSm; CS1∼CSk), die dazu ausgebildet ist, den mindestens einen Sammelkondensator vor dem Beginn einer Messung aufzuladen, wobei die Referenzspannungsquelle dazu ausgebildet ist, die Massespannung auszugeben.

## Claims

1. Circuit arrangement for determining a capacitance of a number n of capacitive sensor elements (SE1∼SEn), the respective capacitance of which changes on the basis of actuation, according to the switched-capacitor principle, comprising a charging cycle and a charge transfer cycle, having
- at least one collecting capacitor (CS1∼CSm; CS1∼CSk),
- a reference voltage source (RQ),
- an evaluation device (AE) which is electrically connected to the at least one collecting capacitor and evaluates a voltage present at the at least one collecting capacitor in order to determine the capacitance of a respective sensor element,
- a control unit (MC) for generating at least one control signal (SS1∼SSk; SS1∼SSm), and
- at least one integrated circuit (IC1∼ICm) which is electrically connected to the reference voltage source and to the at least one collecting capacitor and to which the at least one control signal is applied, the at least one integrated circuit comprising:
- a number k of changeover switches (WS1∼WSk),
- a respective changeover switch being respectively associated with one of the number n of sensor elements,
- a switching position of a respective changeover switch depending on the at least one control signal, and
- a respective changeover switch connecting the respectively associated sensor element to the reference voltage source in a first switching position, corresponding to the charging cycle of the switched-capacitor principle, and the respective changeover switch connecting the respectively associated sensor element to the at least one collecting capacitor in a second switching position for the purpose of charge transfer, corresponding to the charge transfer cycle of the switched-capacitor principle,
wherein the at least one collecting capacitor (CS1∼CSm; CS1∼CSk) is connected with one end to the respective changeover switch (WS1∼WSk) and with the other end is connected to ground (GND),
and wherein means (ES1∼ESm) are provided in order to discharge the collecting capacitor (CS1∼CSm; CS1∼CSk), and the connection of the respective sensor element to the reference voltage source (RQ) is via the respective changeover switch (WS1∼WSk) to a potential (UR) different from ground,
or wherein means (LS1∼LSm) are provided in order to charge the collecting capacitor (CS1∼CSm; CS1∼CSk) at the end not connected to ground with a potential different from ground, and the connection of the respective sensor element to the reference voltage source (RQ) is via the respective changeover switch (WS1∼WSk) to a ground potential (GND).

2. Circuit arrangement according to claim 1, **characterized in that** the number n of capacitive sensor elements is an integer multiple of the number k of controllable changeover switches in the at least one integrated circuit.

3. Circuit arrangement according to claim 1 or 2, **characterized in that** precisely one collecting capacitor is respectively associated with each integrated circuit, the control unit generating a number of different control signals which is equal to the number k of changeover switches in a respective integrated circuit.

4. Circuit arrangement according to claim 1 or 2, **characterized in that** a number of collecting capacitors which is equal to the number of changeover switches in a respective integrated circuit is jointly associated with all integrated circuits, the control unit generating a number of different control signals which is equal to the number of integrated circuits.

5. Circuit arrangement according to any of the preceding claims, **characterized by** at least one charging circuit (LS1∼LSm, LS1∼LSk) as a means for charging the collecting capacitor (CS1∼CSm; CS1∼CSk), which is designed to charge the at least one collecting capacitor before the start of a measurement, the reference voltage source being designed to output the ground voltage.

## Revendications

1. Arrangement de circuit destiné à déterminer une capacité d'un nombre n d'éléments de détection capacitifs (SE1∼SEn), dont la capacité respective varie en fonction de l'actionnement, selon le principe de la capacité commutée, qui comprend un cycle de charge et un cycle de transfert de charge, comprenant
- au moins un condensateur central (CS1∼CSm ; CS1∼CSk),
- une source de tension de référence (RQ),
- une unité d'interprétation (AE) reliée électriquement à l'au moins un condensateur central, laquelle interprète une tension présente aux bornes de l'au moins un condensateur central en vue de déterminer la capacité d'un élément de détection respectif,
- une unité de commande (MC) destinée à générer au moins un signal de commande (SS1∼SSk ; SS1∼SSm) et
- au moins un circuit intégré (IC1∼ICm) qui est relié électriquement à la source de tension de référence et à l'au moins un condensateur central et qui est sollicité par l'au moins un signal de commande, l'au moins un circuit intégré comprenant:
- un nombre k de commutateurs inverseurs (WS1∼WSk),
- un commutateur inverseur respectif étant respectivement associé à l'un du nombre n d'éléments de détection,
- une position de commutation d'un commutateur inverseur respectif étant dépendante de l'au moins un signal de commande et
- un commutateur inverseur respectif dans une première position de commutation reliant l'élément de détection respectivement associé à la source de tension de référence, ce qui correspond au cycle de charge du principe de la capacité commutée, et le commutateur inverseur respectif dans une deuxième position de commutation reliant l'élément de détection respectivement associé à l'au moins un condensateur central en vue du transfert de charge, ce qui correspond au cycle de transfert de charge du principe de la capacité commutée,
l'au moins un condensateur central (CS1∼CSm ; CS1∼CSk) étant relié par une extrémité au commutateur inverseur (WS1∼WSk) respectif et par l'autre extrémité à la masse (GND),
des moyens (ES1∼ESm) étant présents pour décharger le condensateur central (CS1∼CSm ; CS1∼CSk), et la liaison de l'élément de détection respectif à la source de tension de référence (RQ) s'effectuant par le biais du commutateur inverseur (WS1∼WSk) respectif à un potentiel (UR) différent de la masse,
ou des moyens (LS1∼LSm) étant présents pour charger le condensateur central (CS1∼CSm ; CS1∼CSk) au niveau de l'extrémité non reliée à la masse à un potentiel différent de la masse et la liaison de l'élément de détection respectif à la source de tension de référence (RQ) s'effectuant par le biais du commutateur inverseur (WS1∼WSk) respectif à un potentiel de masse (GND).

2. Arrangement de circuit selon la revendication 1, **caractérisé en ce que** le nombre n d'éléments de détection capacitifs est un multiple entier du nombre k de commutateurs inverseurs commandables de l'au moins un circuit intégré.

3. Arrangement de circuit selon la revendication 1 ou 2, **caractérisé en ce qu'**exactement un condensateur central est respectivement associé à chaque circuit intégré, l'unité de commande générant un nombre de signaux de commande différents qui est égal au nombre k de commutateurs inverseurs dans un circuit intégré respectif.

4. Arrangement de circuit selon la revendication 1 ou 2, **caractérisé en ce qu'**un nombre de condensateurs centraux est associé en commun à tous les circuits intégrés, lequel est égal au nombre de commutateurs inverseurs dans un circuit intégré respectif, l'unité de commande générant un nombre de signaux de commande différents qui est égal au nombre de circuits intégrés.

5. Arrangement de circuit selon l'une des revendications précédentes, **caractérisé par** au moins un circuit de charge (LS1∼LSm ; LS1∼LSk) en tant que moyen pour charger le condensateur central (CS1∼CSm ; CS1∼CSk), lequel est configuré pour charger l'au moins un condensateur central avant le début d'une mesure, la source de tension de référence étant configurée pour délivrer la tension de masse.
